# EUROPÄISCHE PATENTANMELDUNG

(11) **EP 4 683 226 A1**
(43) Veröffentlichungstag der Anmeldung: **21.01.2026**
(21) Anmeldenummer: 25187298.2
(22) Anmeldetag: 03.07.2025
(51) Int. Cl.: H03K 17/945, H03K 17/95

(54) **AUSWERTEEINHEIT FÜR NÄHERUNGSSCHALTER**

(30) Priorität: 18.07.2024 LU 103339
(71) Anmelder: PHOENIX CONTACT GMBH & CO. KG, 32825 Blomberg (DE)
(72) Erfinder: ENNS, Andreas, 32689 Kalletal (DE)
(74) Vertreter: Blumbach · Zinngrebe Patentanwälte PartG mbB

(57) **Zusammenfassung**

Die Erfindung sieht eine Auswerteeinheit (100) zur Auswertung eines Ausgangssignals eines Push-Pull-Ausgangs eines Näherungsschalters (400) vor, umfassend
- eine elektrische Schaltung (200) mit wenigstens einem Eingang (430) und einem ersten und zweiten Ausgang (531, 532; 541, 542), wobei der Eingang (430) mit dem Push-Pull-Ausgang des Näherungsschalters (400) verbindbar ist, und wobei die elektrische Schaltung (200) dazu ausgebildet ist, am ersten Ausgang (531, 532) ein Signal auszugeben, wenn der Eingang (430) auf ein positives Potential geschaltet ist, und am zweiten Ausgang (541, 542) ein Signal auszugeben, wenn der Eingang (430) auf Masse geschaltet ist, und
- wenigstens eine mit dem ersten und zweiten Ausgang der elektrischen Schaltung verbundene Auswertelogik (310, 320), welche dazu ausgebildet ist, einen Fehlerzustand zu erkennen.

Ferner sieht die Erfindung ein System mit einem Näherungsschalter und einer solchen Auswerteeinheit vor.

## Beschreibung

Die Erfindung betrifft allgemein die Auswertung von Sensorsignalen, und insbesondere eine Auswerteeinheit zur Auswertung eines Ausgangssignals eines Näherungsschalters.

Näherungsschalter, auch Initiator, Näherungsinitiator, Annäherungsschalter oder Näherungssensor genannt, sind Sensoren, die auf Annäherung, d. h. ohne direkten Kontakt berührungsfrei reagieren. Näherungsschalter werden beispielsweise bei technischen Prozessen zur Positionserkennung von Werkstücken und Werkzeugen sowie als Auslöser von Sicherheitsmaßnahmen eingesetzt, insbesondere im Bereich der Automatisierungstechnik. Es gibt verschiedene Arten von Näherungsschaltern, die unterschiedliche physikalische Größen als Maß für die Annäherung eines Objektes verwenden und dementsprechend unterschiedliche Arten von Sensoren einsetzen. Näherungsschalter werden beispielsweise in DE 3519303 C2, DE 198 05 750 B4 und DE 10 2015 221 342 B4 beschrieben.

Zur Erkennung der Annäherung metallischer Objekte werden häufig induktive Näherungssensoren eingesetzt, wobei ein induktiver Näherungssensor typischerweise einen LC-Schwingkreis umfasst, dessen Spule ein elektromagnetisches Wechselfeld erzeugt, welches sich in den Messbereich erstreckt. Wird ein metallisches Objekt in den Messbereich bewegt, so wird dem Schwingkreis aufgrund von Wirbelströmen im Metall und, im Falle ferromagnetischer Metalle zusätzlich aufgrund von Ummagnetisierungen, Energie entzogen. Diese Dämpfung des Schwingkreises bewirkt eine Stromänderung, die mittels einer Signalauswertung erkannt und in ein Schaltsignal umgesetzt wird. Die beiden Schaltzustände eines induktiven Näherungssensors werden daher als bedämpft bzw. unbedämpft bezeichnet.

Näherungsschalter können verschiedene Arten von Ausgängen aufweisen, wobei häufig PNP- oder NPN-Ausgänge verwendet werden, wobei ein Näherungsschalter mit PNP-Ausgang ein positives Potential auf seinen Ausgang schaltet und ein Näherungsschalter mit NPN-Ausgang die Masse auf seinen Ausgang schaltet.

Typische Näherungsschalter mit PNP-Ausgang haben einen digitalen Ausgang, welcher entweder eine elektrische Spannung (bedämpft = "1") schaltet oder hochohmig (unbedämpft = "0") ist. Durch die Hochohmigkeit des Ausgangs im unbedämpften Zustand kann von der Auswerteeinheit jedoch nicht zwischen einem normalen Schaltzustand und einem Drahtbruchfehler unterschieden werden. Daher werden in der Antriebsüberwachung häufig zwei induktive Näherungsschalter bzw. Initiatoren zur sicheren Erfassung der Drehzahl verwendet. Um einen Drahtbruchfehler zwischen Näherungsschalter und der Auswerteeinheit sicherheitsgerichtet erkennen zu können, dürfen niemals beide Näherungsschalter gleichzeitig unbedämpft sein, es muss also zu jedem Zeitpunkt mindestens einer der beiden Näherungsschalter bedämpft sein. Das bedeutet, dass der Maschinenbauer in dem mechanischen Design seines Antriebs eingeschränkt ist, er muss z.B. eine spezielle Lochscheibe oder ein Zahnrad mit einem asymmetrischen Zahn/Loch Verhältnis konstruieren. Dies wird beispielsweise in Kapitel 4.4.1 der Originalbetriebsanleitung "Drehzahl- und Stillstandswächter PSR-MM30 mit Konfigurations-Software PSRmotion", UM DE PSR-MM30, Revision 07, 2. Februar 2022, anschaulich dargestellt. Die notwendigen Einschränkungen im mechanischen Design können in nachteiliger Weise einen konstruktiven Mehraufwand und somit auch höhere Kosten bedeuten.

Der Erfindung liegt daher die Aufgabe zugrunde, einen Weg aufzuzeigen, wie der Einsatz von Näherungsschaltern vereinfacht und/oder verbessert werden kann, und wie insbesondere eine Fehlererkennung bei der Auswertung von Ausgangssignalen von Näherungsschaltern vereinfacht und/oder verbessert werden kann.

Diese Aufgabe wird durch die Merkmale der unabhängigen Ansprüche gelöst. Vorteilhafte Ausführungsformen sind Gegenstand der abhängigen Ansprüche, wobei die angegebenen Merkmale und Vorteile im Wesentlichen für alle unabhängigen Ansprüche gelten können.

Ein Kerngedanke der Erfindung kann darin gesehen werden, einen Näherungsschalter mit Push-Pull-Ausgang einzusetzen und eine Auswerteeinheit zur Auswertung eines Ausgangssignals des Push-Pull-Ausgangs des Näherungsschalters vorzuschlagen, die dazu ausgebildet ist, einen Fehlerzustand, insbesondere einen Drahtbruchfehler, zu erkennen.

Ein Push-Pull-Ausgang zeichnet sich dadurch aus, dass dieser im ausgeschalteten Zustand nicht hochohmig ist, sondern gegen Masse (GND) schaltet. Ein Näherungsschalter mit Push-Pull-Ausgang schaltet somit je nach Schaltzustand ein positives Potential oder Masse auf seinen Ausgang. Mit anderen Worten schaltet ein Näherungsschalter mit Push-Pull-Ausgang im aktivierten Zustand wie ein aktivierter Näherungsschalter mit PNP-Ausgang und im nicht aktivierten Zustand wie ein aktivierter Näherungsschalter mit NPN-Ausgang.

Gemäß einem ersten Aspekt der Erfindung ist eine Auswerteeinheit zur Auswertung eines Ausgangssignals eines Push-Pull-Ausgangs eines Näherungsschalters vorgesehen, die eine elektrische Schaltung und wenigstens eine mit der elektrischen Schaltung verbundene Auswertelogik umfasst. Die elektrische Schaltung umfasst wenigstens einen Eingang zum Anschließen des Push-Pull-Ausgangs des Näherungsschalters, sowie einen ersten und einen zweiten Ausgang, wobei die elektrische Schaltung dazu ausgebildet ist, am ersten Ausgang ein Signal auszugeben, wenn der Eingang auf ein positives Potential geschaltet ist, und am zweiten Ausgang ein Signal auszugeben, wenn der Eingang auf Masse geschaltet ist. Die wenigstens eine Auswertelogik ist dazu ausgebildet, in Abhängigkeit der an dem ersten und an dem zweiten Ausgang der elektrischen Schaltung ausgegebenen Signale einen Fehlerzustand zu erkennen.

Vorteilhaft wird insbesondere dann ein Fehlerzustand durch die wenigstens eine Auswertelogik erkannt, wenn weder am ersten noch am zweiten Ausgang der elektrischen Schaltung ein Signal ausgegeben wird, wobei insbesondere ein Drahtbruch zwischen dem Näherungsschalter und der elektrischen Schaltung zum Erkennen eines Fehlerzustands führt. Die Auswertelogik umfasst zu diesem Zweck vorteilhaft einen Mikrocontroller, wobei die Erkennung eines Fehlerzustands vorzugsweise mittels einer Firmware des Mikrocontrollers erfolgen kann.

Bevorzugt umfasst die elektrische Schaltung der Auswerteeinheit einen ersten Schaltungsteil zum Ausgeben eines Signals am ersten Ausgang und einen zweiten Schaltungsteil zum Ausgeben eines Signals am zweiten Ausgang. Der erste Schaltungsteil ist vorzugsweise dazu ausgebildet, ein am Eingang anliegendes Massepotential zu erkennen und in Antwort ein Signal am ersten Ausgang auszugeben. Der zweite Schaltungsteil ist vorzugsweise dazu ausgebildet, ein am Eingang anliegendes positives Potential zu erkennen und in Antwort ein Signal am zweiten Ausgang auszugeben.

Besonders vorteilhaft umfasst der erste Schaltungsteil einen Komparator, um eine Spannung mit einer ersten vorgegebenen Referenzspannung zu vergleichen und in Abhängigkeit des Vergleichsergebnisses am ersten Ausgang ein Signal auszugeben, wobei am ersten Ausgang ein Signal ausgegeben wird, wenn ein Strom vom ersten Schaltungsteil zum Eingang der Auswerteeinheit fließt. Analog umfasst der zweite Schaltungsteil ebenfalls besonders vorteilhaft einen Komparator, um eine Spannung mit einer zweiten vorgegebenen Referenzspannung zu vergleichen und in Abhängigkeit des Vergleichsergebnisses am zweiten Ausgang ein Signal auszugeben, wobei am zweiten Ausgang ein Signal ausgegeben wird, wenn ein Strom vom Eingang der Auswerteeinheit zum zweiten Schaltungsteil fließt.

Die erste und die zweite Referenzspannung sind vorzugsweise so gewählt, dass im fehlerfreien Betrieb immer entweder am ersten oder am zweiten Ausgang ein Signal ausgegeben wird, so dass ein Fehlerzustand, insbesondere ein Drahtbruch zwischen dem Näherungsschalter und der elektrischen Schaltung, erkannt werden kann, wenn an keinem der Ausgänge ein Signal ausgegeben wird. Vorteilhaft können die erste und die zweite Referenzspannung identisch sein, d.h. es kann eine gemeinsame Referenzspannung für beide Schaltungsteile vorgesehen sein.

Zweckmäßigerweise können der erste und/oder der zweite Schaltungsteil Schaltungselemente zur Signalanpassung, zur Strombegrenzung und/oder zur Filterung umfassen. Ferner umfasst die Auswerteinheit vorteilhaft weitere Anschlüsse, um einen angeschlossenen Näherungsschalter mit einer Spannungsversorgung und mit Masse zu verbinden.

Zur sicheren zweikanaligen Auswertung umfasst die Auswerteeinheit vorzugsweise zwei jeweils mit dem ersten und zweiten Ausgang der elektrischen Schaltung verbundene Auswertelogiken, insbesondere zwei Mikrocontroller-Logiken.

Gemäß einem zweiten Aspekt der Erfindung ist ein System vorgesehen, welches eine oben beschriebene Auswerteeinheit und einen mit der Auswerteeinheit verbundenen Näherungsschalter mit Push-Pull-Ausgang umfasst.

Die Erfindung wird nachfolgend anhand von Ausführungsbeispielen in Verbindung mit den Zeichnungen näher erläutert. Es zeigt:

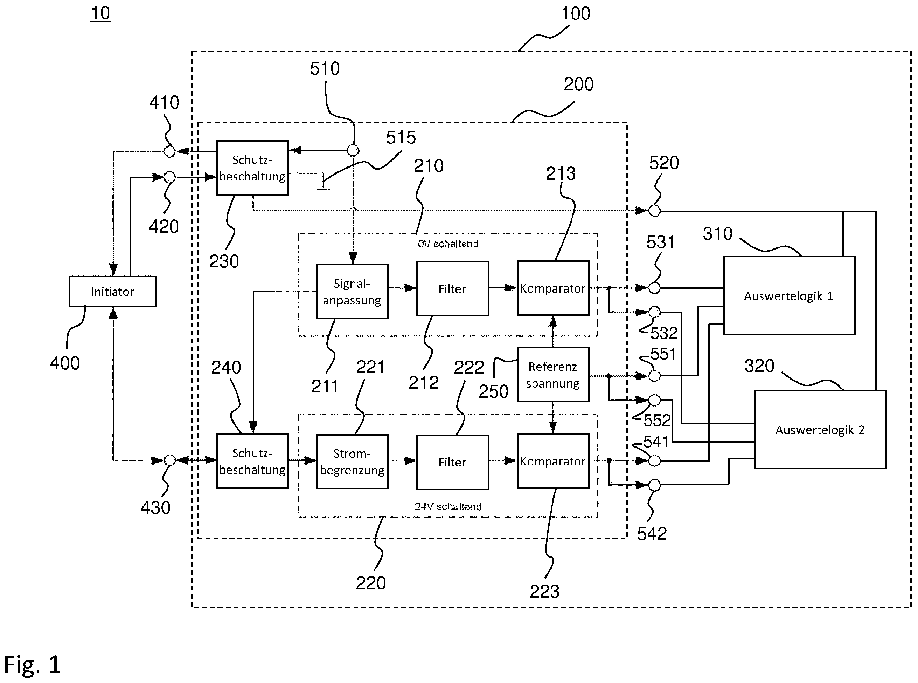

- Figur 1: eine schematische Darstellung eines erfindungsgemäßen Systems mit einer bevorzugten Ausführungsform einer erfindungsgemäßen Auswerteinheit als Blockschaltbild.

Fig. 1 zeigt schematisch ein System 10 mit einem induktiven Näherungsschalter 400, in der Figur als Initiator bezeichnet, welcher an eine Auswerteeinheit 100 angeschlossen ist. Die Auswerteeinheit 100 ist dazu ausgebildet, in Abhängigkeit des am Eingang 430 anliegenden Signals drei Zustände des Push-Pull Ausgangs des Näherungsschalters 400 zu erkennen, "bedämpft", "unbedämpft" und "Hochohmigkeit" bzw. "Drahtbruch". Dazu umfasst die Auswerteeinheit 100 im dargestellten Ausführungsbeispiel eine elektrische Schaltung 200, die zur Signalisierung des Zustands Signale an eine Auswertelogik ausgibt, wobei die Auswertelogik im dargestellten Ausführungsbeispiel als sichere, zweikanalige Mikrocontroller-Logik aufgebaut ist und eine erste Mikrocontroller-Logik 310 und eine zweite Mikrocontroller-Logik 320 umfasst, wobei die Mikrocontroller-Logiken 310 und 320 die Ausgangssignale der elektrischen Schaltung 200 redundant auswerten. Es ist anzumerken, dass für nicht sicherheitsrelevante Einsatzzwecke vorteilhaft auch nur eine Auswertelogik vorgesehen sein kann.

Im dargestellten Ausführungsbeispiel umfasst die elektrische Schaltung ferner eine Versorgungsspannung 510, die eine Gleichspannung von beispielsweise +24 V bereitstellt, sowie eine Verbindung zu Masse 515. Über eine Schutzbeschaltung 230 ist das positive Spannungspotential mit dem Anschluss 410 und die Masse mit dem Anschluss 420 der elektrischen Schaltung 200 verbunden. Die Anschlüsse 410 und 420 sind mit entsprechenden Anschlüssen des Näherungsschalters 400 verbunden, so dass dieser mit dem positiven Potential und mit Masse verbunden ist, wobei der Näherungsschalter 400 im aktivierten Zustand das positive Potential und im nicht aktivierten Zustand die Masse auf seinen mit dem Eingang 430 der elektrischen Schaltung 200 verbundenen Ausgang schaltet.

Zur Erkennung des Zustands des Push-Pull Ausgangs des Näherungsschalters 400 kann die elektrische Schaltung 200 einen Strom treiben oder einen Strom aufnehmen. Die Auswertung der Zustände auf Plausibilität erfolgt dann jeweils in der Firmware der Mikrocontroller der Auswertelogiken 310 und 320. Die elektrische Schaltung 200 der Auswerteeinheit 100 umfasst intern zwei Schaltungsteile 210 und 220, wobei der erste Schaltungsteil 210 erkennt, wenn der Eingang 430 gegen Masse 515 geschaltet wird ("0V schaltend"), und wobei der zweite Schaltungsteil 220 erkennt, wenn der Eingang 430 gegen die Versorgungsspannung 510 geschaltet wird ("24V schaltend").

Die Versorgungsspannung 510 ist mit dem ersten Schaltungsteil 210 verbunden, und zwar im dargestellten Ausführungsbeispiel mit einem Schaltungselement zur Signalanpassung 211, wobei dieses Schaltungselement zur Signalanpassung 211 ferner mit einer Schutzbeschaltung 240 verbunden ist, welche zwischen den Eingang 430 und den zweiten Schaltungsteil 220 geschaltet ist.

Liegt am Eingang 430 der elektrischen Schaltung 200 ein Massepotential an, so fließt ein Strom aus dem 0V-Schaltungsteil 210 in diese Masse. Durch die Signalanpassung 211 wird dieses Signal über einen Filter 212 an einen Komparator 213 geführt. Der Komparator 213 vergleicht das Eingangssignal mit einer Referenzspannung 250 und gibt das Ergebnis über einen ersten Ausgang der elektrischen Schaltung 200 an die sichere Auswertelogik weiter. Durch die Verwendung von Referenzspannung und Komparator ist es möglich, genaue Schaltschwellen einzustellen und eine hohe Flankensteilheit zu erreichen. Im dargestellten Ausführungsbeispiel wird der erste Ausgang der elektrischen Schaltung 200 an dem mit der ersten Auswertelogik 310 verbundenen Anschluss 531 und an dem mit der zweiten Auswertelogik 320 verbundenen Anschluss 532 bereitgestellt.

Liegt an dem Eingang 430 eine 24V-Spannung an, so fließt ein Strom in den 24V-Schaltungsteil 220 der elektrischen Schaltung 200. Das Signal wird zunächst an ein Schaltungselement zur Strombegrenzung 221, und von diesem auch hier über einen Filter 222 an einen Komparator 223 geführt, mit der Referenzspannung 250 verglichen und über einen zweiten Ausgang an die sichere Auswertelogik weitergegeben. Im dargestellten Ausführungsbeispiel wird der zweite Ausgang der elektrischen Schaltung 200 an dem mit der ersten Auswertelogik 310 verbundenen Anschluss 541 und an dem mit der zweiten Auswertelogik 320 verbundenen Anschluss 542 bereitgestellt.

Die Referenzspannung 250 ist vorteilhaft einstellbar, wobei auch für jeden der Komparatoren 213 und 223 jeweils eine separate, insbesondere einstellbare, Referenzspannung vorgesehen sein kann.

Je ein Schaltungsteil ist also für die Erkennung eines der beiden definierten Eingangssignale zuständig. Liegt kein Fehler vor, so ist immer nur einer der beiden Schaltungsteile aktiv. Wenn jedoch keiner der beiden Schaltungsteile aktiv ist, dann liegt ein unplausibler Zustand vor und die Auswertelogik schließt daraus auf einen dritten Zustand, insbesondere einen Fehlerzustand, der sich als Hochohmigkeit des Eingangs 430 darstellt. Dies ist dann der Fall, wenn ein Drahtbruch zwischen Näherungsschalter 400 und Auswerteeinheit 100 auftritt, insbesondere zwischen dem Näherungsschalter 400 und dem Eingang 430.

Im dargestellten Beispiel ist die Versorgungsspannung 510 über die Schutzbeschaltung 230 mit dem Anschluss 520 der elektrischen Schaltung 200 verbunden, wobei die Auswertelogiken 310 und 320 mit dem Anschluss 520 verbunden sind und über diesen mit Spannung versorgt werden.

Vorteilhaft wird auch die Referenzspannung 250 den Auswertelogiken 310 und 320 zugeführt, beispielsweise zu Kontrollzwecken. Im dargestellten Ausführungsbeispiel erfolgt dies über die Anschlüsse 551 und 552 der elektrischen Schaltung 200.

Die Erfindung ermöglicht in vorteilhafter Weise durch den Einsatz eines Näherungsschalters mit Push-Pull-Ausgang und der beschriebenen Auswerteeinheit eine Drahtbrucherkennung. Es wird dabei vorteilhaft ausgenutzt, dass Push-Pull-Ausgänge im ausgeschalteten Zustand nicht hochohmig sind, sondern gegen Masse schalten. Dieser Zustand wird durch die vorgeschlagene Auswerteeinheit sicher überwacht, so dass zwischen dem unbedämpften Zustand und Drahtbruch unterschieden werden kann.

Vorteilhaft ermöglicht die Erfindung, zu jeder Zeit einen Drahtbruch in der Leitung eines Näherungsschalters zu erkennen. Besonders vorteilhaft wird durch die Erfindung bei Antriebsüberwachungen mittels induktiven Näherungsschaltern eine Drahtbrucherkennung realisiert, wodurch die sonst erforderliche Anforderung entfällt, dass immer mindestens ein Näherungsschalter bedämpft sein muss. Dies bietet den besonderen Vorteil, dass der Anwender flexibler im mechanischen Design seines Antriebs ist, da die strengen Anforderungen an das mechanische Design des zu überwachenden Antriebs wegfallen.

### Bezugszeichenliste:

- 10: System mit Auswerteeinheit und angeschlossenem Näherungsschalter
- 100: Auswerteeinheit
- 200: elektrische Schaltung
- 210: erster Schaltungsteil
- 211: Schaltungselement zur Signalanpassung
- 212, 222: Filter
- 213, 223: Komparator
- 220: zweiter Schaltungsteil
- 221: Strombegrenzung
- 230, 240: Schutzbeschaltung
- 250: Referenzspannung
- 310, 320: Auswertelogik
- 400: Induktiver Näherungsschalter
- 410: Anschluss zur Spannungsversorgung des Näherungsschalters
- 420: Masseanschluss
- 430: Eingang der Auswerteeinheit
- 510: Spannungsversorgung
- 515: Masse
- 520: Ausgang zum Bereitstellen der Versorgungsspannung
- 531, 532: erster Ausgang der Auswerteeinheit
- 541, 542: zweiter Ausgang der Auswerteeinheit
- 551, 552: Ausgang zum Bereitstellen der Referenzspannung

## Patentansprüche

1. Auswerteeinheit (100) zur Auswertung eines Ausgangssignals eines Push-Pull-Ausgangs eines Näherungsschalters (400), wobei auf den Push-Pull-Ausgang (430) je nach Schaltzustand des Näherungsschalters (400) ein positives Potential (500) oder Masse geschaltet ist, umfassend
- eine elektrische Schaltung (200) mit wenigstens einem Eingang (430) und einem ersten und zweiten Ausgang (531, 532; 541, 542), wobei der Eingang (430) mit dem Push-Pull-Ausgang des Näherungsschalters (400) verbindbar ist, und wobei die elektrische Schaltung (200) dazu ausgebildet ist, am ersten Ausgang (531, 532) ein Signal auszugeben, wenn der Eingang (430) auf Masse geschaltet ist, und am zweiten Ausgang (541, 542) ein Signal auszugeben, wenn der Eingang (430) auf ein positives Potential geschaltet ist, und
- wenigstens eine mit dem ersten und zweiten Ausgang der elektrischen Schaltung verbundene Auswertelogik (310, 320), welche dazu ausgebildet ist, einen Fehlerzustand zu erkennen.

2. Auswerteeinheit nach Anspruch 1, wobei ein Fehlerzustand erkannt wird, wenn weder am ersten noch am zweiten Ausgang (531, 532; 541, 542) der elektrischen Schaltung ein Signal ausgegeben wird.

3. Auswerteeinheit nach Anspruch 1 oder 2, dazu ausgebildet, im Falle eines Drahtbruchs zwischen Näherungsschalter (400) und Auswerteeinheit (100) einen Fehlerzustand zu erkennen.

4. Auswerteeinheit nach einem der Ansprüche 1 bis 3, wobei die elektrische Schaltung (200) einen ersten und einen zweiten Schaltungsteil (210, 220) aufweist, wobei der erste Schaltungsteil (210) dazu ausgebildet ist, ein am Eingang (430) anliegendes Massepotential zu erkennen und in Antwort ein Signal am ersten Ausgang (531, 532) auszugeben, und wobei der zweite Schaltungsteil (220) dazu ausgebildet ist, ein am Eingang (430) anliegendes positives Potential zu erkennen und in Antwort ein Signal am zweiten Ausgang (541, 542) auszugeben.

5. Auswerteeinheit nach Anspruch 4, wobei der erste Schaltungsteil (210) einen Komparator (213) umfasst, um eine Spannung mit einer ersten vorgegebenen Referenzspannung (250) zu vergleichen und in Abhängigkeit des Vergleichsergebnisses am ersten Ausgang (531, 532) ein Signal auszugeben, wobei am ersten Ausgang ein Signal ausgegeben wird, wenn ein Strom vom ersten Schaltungsteil zum Eingang (430) fließt, und/oder der zweite Schaltungsteil (220) einen Komparator (223) umfasst, um eine Spannung mit einer zweiten vorgegebenen Referenzspannung (250) zu vergleichen und in Abhängigkeit des Vergleichsergebnisses am zweiten Ausgang (541, 542) ein Signal auszugeben, wobei am zweiten Ausgang ein Signal ausgegeben wird, wenn ein Strom vom Eingang zum zweiten Schaltungsteil fließt.

6. Auswerteeinheit nach Anspruch 5, wobei eine gemeinsame Referenzspannung (250) als erste und zweite Referenzspannung vorgesehen ist.

7. Auswerteeinheit nach einem der Ansprüche 4 bis 6, wobei der erste und/oder der zweite Schaltungsteil (210, 220) Schaltungselemente zur Signalanpassung (211), zur Strombegrenzung (221) und/oder zur Filterung (212, 222) umfasst.

8. Auswerteeinheit nach einem der vorstehenden Ansprüche, wobei die Auswerteeinheit (100) zur sicheren zweikanaligen Auswertung zwei jeweils mit dem ersten und zweiten Ausgang der elektrischen Schaltung verbundene Auswertelogiken (310, 320) umfasst.

9. System (10), umfassend einen Näherungsschalter (400) mit Push-Pull-Ausgang und eine mit dem Push-Pull-Ausgang des Näherungsschalters verbundene Auswerteeinheit (100) nach einem der Ansprüche 1 bis 8.
